(19) Europäisches Patentamt
European Patent Office
Office européen des brevets

(11) **EP 4 369 243 A1**

(12) **EUROPEAN PATENT APPLICATION**

(43) Date of publication:
**15.05.2024 Bulletin 2024/20**

(21) Application number: **23209777.4**

(22) Date of filing: **14.11.2023**

(51) International Patent Classification (IPC):
**G06F 30/30** (2020.01)        **G09G 3/3225** (2016.01)
**G09G 3/3233** (2016.01)

(52) Cooperative Patent Classification (CPC):
**G09G 3/3233; G06F 30/30; G09G 3/3225;**
G09G 2300/0819; G09G 2300/0852;
G09G 2300/0861; G09G 2300/0866;
G09G 2310/0251; G09G 2310/0256

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **14.11.2022 US 202263425194 P
31.05.2023 US 202318326951**

(71) Applicant: **Samsung Display Co., Ltd.
Yongin-si, Gyeonggi-do 17113 (KR)**

(72) Inventors:
• **BLESENER, Yannick
San Jose, 95134 (US)**
• **QU, Shuhui
San Jose, 95134 (US)**
• **WANG, Zheng
San Jose, 95134 (US)**

(74) Representative: **Marks & Clerk LLP
15 Fetter Lane
London EC4A 1BW (GB)**

(54) **SYSTEM AND METHOD FOR MULTI-STAGE DISPLAY CIRCUIT INPUT DESIGN**

(57)    A method of designing inputs of a circuit includes identifying, by a circuit input solver, input ports of the circuit, classifying, by the circuit input solver, each one of the input ports as a DC line port of a plurality of DC line ports or a switching control line port of a plurality of switching control line ports, identifying, by the circuit input solver, one of the DC line ports as a data line port, determining, by the circuit input solver, for an emission phase of the circuit, a plurality of first parameters corresponding to signals of the plurality of DC line ports, and determining, by the circuit input solver, for an initialization phase of the circuit, a plurality of second parameters corresponding to signals of the plurality of switching control line ports based on the plurality of first parameters.

FIG. 3

EP 4 369 243 A1

**EP 4 369 243 A1**

## Description

### FIELD

Aspects of some embodiments of the present disclosure relate to design of electronic circuits.

### BACKGROUND

The recent years have witnessed a rapid growth in display technology as display modules penetrate our daily lives through smart and interactive devices such as smart phones, smart watches, inside cars, and on edge devices as part of the internet of things. Accompanied by this rise, is a demand for ever greater image and video quality as well as customized designs catered to specific needs of the application.

Historically, the design of display circuits has largely been driven by the ingenuity of engineers as well as large scale simulation experiments throughout the design process to find a pixel circuit topology and the required inputs to drive the circuit to a desired behavior.

The above information disclosed in this Background section is only for enhancement of understanding of the background and therefore the information discussed in this Background section does not necessarily constitute prior art.

### SUMMARY

Aspects of embodiments of the present disclosure are directed to methods for automated circuit input design and systems implementing the same. According to some embodiments, for a given pixel circuit topology, the presented method determines the appropriate DC and time varying inputs to the pixel circuit to satisfy desirable constraints such as the ability to control brightness and to correct for hardware specific brightness variations.

According to some embodiments of the present disclosure, there is provided a method of designing inputs of a circuit, the method including: identifying, by a circuit input solver, input ports of the circuit; classifying, by the circuit input solver, each one of the input ports as a DC line port of a plurality of DC line ports or a switching control line port of a plurality of switching control line ports; identifying, by the circuit input solver, one of the DC line ports as a data line port; determining, by the circuit input solver, for an emission phase of the circuit, a plurality of first parameters corresponding to signals of the plurality of DC line ports; determining, by the circuit input solver, for an initialization phase of the circuit, a plurality of second parameters corresponding to signals of the plurality of switching control line ports based on the plurality of first parameters; and transmitting, by the circuit input solver, the first and second parameters for configuring a display device comprising the circuit. The transmitted outputs may be used to design and manufacture a display device comprising the circuit.

In some embodiments, the circuit is a pixel circuit, wherein the emission phase is immediately subsequent to the initialization phase.

In some embodiments, during the initialization phase, the circuit is configured to charge a capacitor of the circuit to a charge level, and, during the emission phase, the circuit is configured to emit light of an intensity corresponding to the charge level of the capacitor during the initialization phase.

In some embodiments, the plurality of first parameters includes voltage levels at the plurality of DC line ports and the plurality of switching control line ports, an emission voltage level of the data line port, signal types of switching signals associated with the plurality of switching control line ports, and a capacitance of a capacitor of the circuit.

In some embodiments, the signal types include an active-low signal type and an active-high signal type, and the voltage levels are between a set maximum value and a set minimum value.

In some embodiments, the plurality of second parameters includes timings of switching signals associated with the plurality of switching control line ports, voltage levels of a subset of DC line ports from among the plurality of DC line ports, an initialization voltage level of the data line port, and a timing and a duration of a data signal at the data line port.

In some embodiments, each DC line port of the subset of DC line ports does not supply current to a light emitting diode (LED) of the circuit during the emission phase of the circuit.

In some embodiments, the identifying the input ports of the circuit includes: converting, by the circuit input solver, a circuit schematic of the circuit to a DC graph representation; and identifying, by the circuit input solver, the input ports based on the DC graph representation.

In some embodiments, the converting the design parameters of the circuit to the DC graph representation includes: converting a capacitor of the circuit to an open circuit; converting a gate-source connection of a transistor of the circuit and a gate-drain connection of the transistor to an open circuit; converting a drain-source connection of the circuit to a short circuit; and converting a diode of the circuit to a short circuit.

In some embodiments, the classifying each one of the input ports includes performing a graph gate search in a DC graph representation of the circuit.

2

In some embodiments, classifying each one of the input ports includes: identifying, through a DC graph representation, a first input port of the input ports that is not connected to a transistor gate as the DC line port; and identifying, through the DC graph representation, a second input port of the input ports that is connected to a transistor gate as the switching control line port.

In some embodiments, the determining, for the emission phase of the circuit, the plurality of first parameters includes: associating one or more dummy variables with a capacitor of the circuit, the one or more dummy variables corresponding to charge levels of the capacitor at successive white and black emission frames; and determining voltage levels of the plurality of DC line ports and the plurality of switching control line ports, an emission voltage level of the data line port, signal types of switching signals associated with the plurality of switching control line ports, and the one or more dummy variables based on one or more constraints.

In some embodiments, the one or more constraints include: a black light emission threshold; and a white light emission threshold.

In some embodiments, the determining, for the initialization phase of the circuit, the plurality of second parameters includes: identifying a subset of DC line ports from among the plurality of DC line ports that do not supply current to a light emitting diode (LED) of the circuit during the emission phase of the circuit; and determining timings of switching signals associated with the plurality of switching control line ports, voltage levels of the subset of DC line ports, an initialization voltage level of the data line port, and a timing and a duration of a data signal at the data line port based on one or more constraints.

In some embodiments, the one or more constraints includes: a time gap between a data signal of the data line port and the switching signals of the plurality of switching control line ports; and a difference or ratio in currents of a light emitting diode (LED) between black and white frames.

In some embodiments, the method further includes: calculating, by the circuit input solver, a total cost including a first cost associated with a black emission frame and a second cost associated with a white emission frame; determining, by the circuit input solver, that the total cost is less than a previous total cost associated with a different one of the DC line ports being identified as the data line port; and identifying, by the circuit input solver, the plurality of first and second parameters as corresponding to designed inputs of the circuit.

In some embodiments, the first cost is expressed as:

$$C_B = \max\left(0, \log\left[\frac{I_{measure(B)}}{I_{target(B)}}\right]\right)$$

, where $C_B$ represents the first cost, log() represents a logarithmic function, $I_{measure(B)}$ represents a measured current of a light emitting diode (LED) of the circuit during the black emission frame, $I_{target(B)}$ represents a target LED current during the black emission frame, and max($a$, $b$) is a function that returns a higher of the two values $a$ and $b$.

In some embodiments, the second cost is expressed as:

$$C_W = \max\left(0, \log\left[\frac{I_{target(B)}}{I_{measure(W)}}\right]\right)$$

, where $C_W$ represents the second cost, log() represents a logarithmic function, $I_{measure(W)}$ represents a measured current of a light emitting diode (LED) of the circuit during the white emission frame, $I_{target(W)}$ represents a target LED current during the white emission frame, and max($a$, $b$) is a function that returns a higher of the two values $a$ and $b$.

According to some embodiments of the present disclosure, there is provided a non-transitory computer readable medium for designing inputs of a circuit, the non-transitory computer readable medium having computer code that, when executed on a processor, implements a method of database management, the method comprising: identifying, by a circuit input solver, input ports of the circuit; classifying, by the circuit input solver, each one of the input ports as a DC line port of a plurality of DC line ports or a switching control line port of a plurality of switching control line ports; identifying, by the circuit input solver, one of the DC line ports as a data line port; determining, by the circuit input solver, for an emission phase of the circuit, a plurality of first parameters corresponding to signals of the plurality of DC line ports; determining, by the circuit input solver, for an initialization phase of the circuit, a plurality of second parameters corresponding to signals of the plurality of switching control line ports based on the plurality of first parameters; and transmitting the first and second parameters for configuring a display device comprising the circuit.

According to some embodiments of the present disclosure there is provided a method of designing inputs of a circuit, the method including: identifying, by a circuit input solver, input ports of the circuit; classifying, by the circuit input solver, each one of the input ports as a DC line port of a plurality of DC line ports or a switching control line port of a plurality of switching control line ports; identifying, by the circuit input solver, one of the DC line ports as a data line port; determining, by the circuit input solver, for an emission phase of the circuit, a plurality of first parameters corresponding to signals of the plurality of DC line ports; determining, by the circuit input solver, for an initialization phase of the circuit, a plurality of second parameters corresponding to signals of the plurality of switching control line ports based on the plurality of first parameters; calculating, by the circuit input solver, a total cost including a first cost associated with a black emission frame and a second cost associated with a white emission frame; determining, by the circuit input solver, that the total cost is less than a previous total cost associated with a different one of the DC line ports being identified as the data line port; identifying, by the circuit input solver, the plurality of first and second parameters as corresponding to designed inputs of the circuit; and transmitting, by the circuit input solver, the first and second parameters for configuring a display device comprising the circuit.

According to some embodiments of the present disclosure, there is provided a circuit input solver including: a processor; and a processor memory local to the processor, wherein the processor memory has stored thereon instructions that, when executed by the processor, cause the processor to perform: identifying input ports of a circuit; classifying each one of the input ports as a DC line port of a plurality of DC line ports or a switching control line port of a plurality of switching control line ports; identifying one of the DC line ports as a data line port; determining, for an emission phase of the circuit, a plurality of first parameters corresponding to signals of the plurality of DC line ports; determining, for an initialization phase of the circuit, a plurality of second parameters corresponding to signals of the plurality of switching control line ports based on the plurality of first parameters; and transmitting, by the circuit input solver, the first and second parameters for configuring a display device comprising the circuit.

Other aspects, features, and characteristics that are not described above will be more clearly understood from the accompanying drawings, claims, and detailed description.

At least some of the above and other features of the invention are set out in the claims.

## BRIEF DESCRIPTION OF THE DRAWINGS

Non-limiting and non-exhaustive embodiments according to the present disclosure are described with reference to the following figures, wherein like reference numerals refer to like parts throughout the various views unless otherwise specified.

FIG. 1A illustrates the topology of a pixel circuit, according to some examples.

FIG. 1B illustrates the inputs designed to operate the pixel circuit so as to produce a desired lighting profile, according to some examples.

FIG. 2 illustrates a block diagram of a circuit input solver, according to some embodiments of the present disclosure.

FIG. 3 illustrates a process of designing inputs of a pixel circuit by the circuit input solver, according to some embodiments of the present disclosure.

FIG. 4 illustrates successive white and black frames produced by the pixel circuit given a particular set of first and second parameters, according to some embodiments of the present disclosure.

FIGS. 5A-5C illustrate the capability of the circuit input solver to design the input signals to a sample pixel circuit as compared to human-designed input signals, according to some embodiments of the present disclosure.

## DETAILED DESCRIPTION

Hereinafter, aspects of some example embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

One of the challenges in designing inputs of a pixel circuit topology is that the design space (i.e., the space of all possible input combinations) is very large with a mostly flat loss surface and narrow and steep local optima. This is due to the fact that modern pixel circuits have multiple inputs that control signal flow and compensation mechanisms within the pixel circuit (e.g., 7T1C pixel circuit has a total 9 voltage inputs), and each input is characterized by (discrete) voltage level(s) and (discrete) switching times of signal and control pulses. Unless the control pulses follow a specific sequence of well-coordinate pulses that depends on the data signal, the circuit is not able to read, store, and display the desired brightness, much less be able to run device-specific corrections (such as correction for thermal thresholds in the driving transistor T1). Overall, this leads to a large design space (exponentially many combinations of potential inputs) with as little as one specific input combination that is able to drive the desired action of the circuit, while all others lead to little to no change in outcome.

Simulating such a large design space has a high computational cost. To guide the search for correct inputs for an arbitrary circuit topology an input design method would need to probe the function of the circuit through sample inputs whose corresponding output (e.g., the brightness levels in the LED) needs to be computed. Generally, this is done through circuit simulations. Depending on the circuit and the computer hardware, as well the scenarios that are to be modeled, a simulation can take several seconds per run. To achieve results with high performance for advanced pixel circuits with intricate topology and narrow viable input space, input search methods may involve several hundreds or thousands of sample evaluations which accumulates to high overall computation time.

Accordingly, aspects of the present disclosure are directed to a circuit input solver (e.g., a pixel circuit input solving system) utilizing a robust general purpose design process applicable to all pixel circuits, which determines (e.g., optimizes) the control inputs of a given pixel circuit with respect to objectives regarding the brightness and stability of the pixel circuit. In addition, the design process utilizes fewer evaluation runs for the pixel simulation than the related art.

In some embodiments, the circuit input solver is a two-step solver that utilizes the timing structure common to pixel circuits of a first initialization phase followed by an emission phase. By determining the input signal solutions (e.g., solving the optimization) in reverse order (i.e., emission phase first, initialization phase second) the complexity of the design space may be greatly reduced. During the emission phase, the circuit input solver treats the charge value in the storage element (i.e., the storage capacitor), which is common to pixel circuits, as a dummy variable in the input design. This treatment allows solving for the emission phase independent of the initialization phase. The circuit input solver also reduces the search space further by classifying inputs as either DC (i.e., constant voltage) inputs or switching control signal inputs based on a graph search within the circuit schematic, which leads to fewer evaluation runs and faster results.

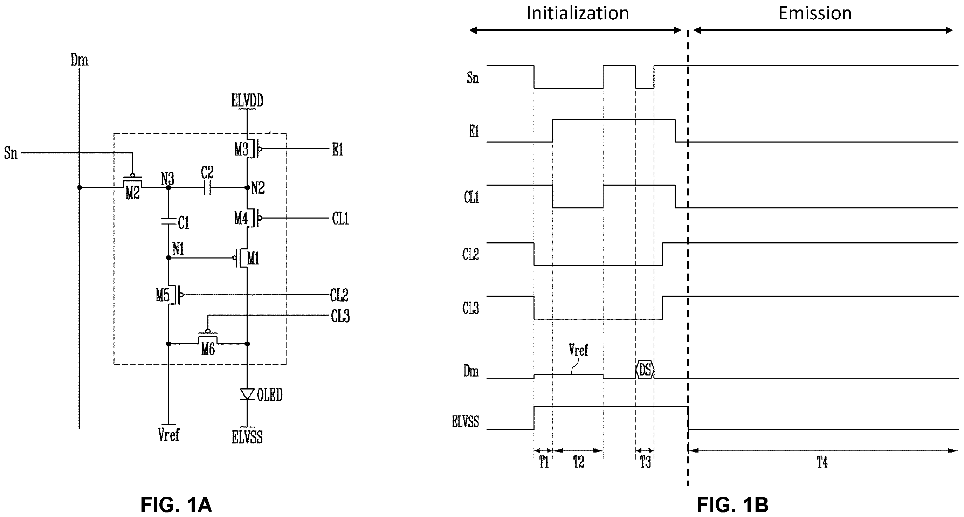

FIG. 1A illustrates the topology of a pixel circuit, according to some examples. FIG. 1B illustrates the inputs designed to operate the pixel circuit so as to produce a desired lighting profile, according to some examples.

As shown in FIG. 1A, a pixel circuit (e.g., a pixel driving circuit) often includes a plurality of transistors (e.g., M1-M6), a storage capacitor (e.g., C1), and an organic light emitting diode (OLED). The transistors may include a driving transistor (e.g., M1) and one or more switching transistors (e.g., M2-M6), which are driven by the input signals to generate an appropriate drive current at the OLED. The OLED in turn produces light of an intensity that corresponds to (e.g., is proportional to) the drive current. The storage capacitor stores the necessary gate voltage of the driving transistor. The transistors may include thin-film transistors (TFT), which may not have uniform characteristics (e.g., carrier mobility, threshold voltage (Vth), etc.). Thus, in addition to driving the OLED, the plurality of transistors may also compensate for the TFT non-uniformity and produce a uniform voltage-to-brightness relationship.

Referring to FIG. 1B, each frame is divided into an initialization phase and an emission phase. During the initialization phase, the gate voltage of the driving transistor, which is stored in the storage capacitor, is appropriately initialized based on a data signal at a data line port. During the emission phase, the OLED emits a light corresponding to the OLED current, which is affected by the stored voltage at the storage capacitor.

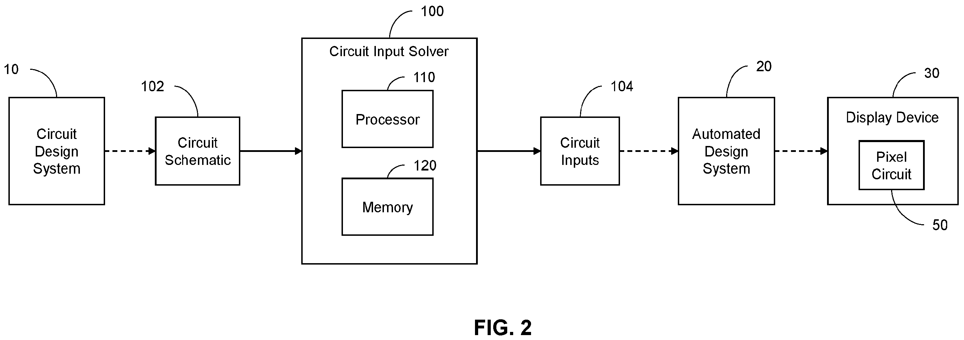

FIG. 2 illustrates a block diagram of a circuit input solver 100, according to some embodiments of the present disclosure.

In some embodiments, the circuit input solver 100 is configured to receive design parameters 102 of a pixel circuit 50 that correspond to (e.g., define) the circuit schematic of the pixel circuit 50 (such as that of FIG. 1A), and to generate a circuit input signals 104 (such as that of FIG. 1B) corresponding to the pixel circuit 50 that provide the desired OLED current and the operational parameters. The design parameters may be generated by (e.g., automatically generated by) a circuit design system 10 that generates the schematic of the pixel circuit 50, which defines the electrical components making up the pixel circuit 50 as well as their interconnections. The input signals 104 generated by the circuit input solver 100 include the timing and voltage levels of the DC and switching signals that are applied to input ports of the pixel circuit 50 during the initialization phase and the emission phase and determine the operation of the pixel circuit 50.

According to some embodiments, to reduce the search space of all possible signals, the circuit input solver 100 exploits the bifurcation of a frame into initialization and emission phases and first solves for the input signals during the emission phase, and then using this solution, solves for the input signals during the initialization phase. In some embodiments, the circuit input solver 100 analytically decouples the two phases of a frame by using dummy variables to represent the capacitance of the capacitors in the pixel circuit 50.

In other words, rather than solve for the values and timings of the input signals during the entirety of the frame, the method of automated circuit input design according to some embodiments, first solves for the voltage levels at the emission phase and then works backwards to solve for the voltages and timings of the input signals during the initialization phase. This process is performed after making an assumption regarding which of the input ports of the pixel circuit 50 is the data line port. The process is then repeated for an assumption of a different one of the input ports being the data line port. At each iteration of the process, the OLED current during the emission phase is compared with the target current (i.e., the desired OLED current), and the data line port assumption and the timing signals that generate the OLED current closest to the target current are chosen as the final solution.

In some examples, the circuit inputs 104 that are generated by the circuit input solver 100 may be supplied to a display device for display to a user. In other examples, the circuit inputs 104 may be provided to an automated design system 20 that is capable of automatically configuring and/or designing some aspects of a display device 30 that includes the pixel circuits 50 matching that of the circuit schematic 102. For example, an automated design system 20 may automatically configure/design control and drive circuitry of the display device 30 to generate the circuit inputs 104 that control the operation of the pixel circuit 50 during the initialization and emission phases. Thus, the circuit input solver 100, as part of a larger automated system, may aid or facilitate the automatic design and/or manufacture of the display device.

According to some embodiments, the circuit input solver 100 includes a processor (e.g., processing circuit) 110 and a memory 120 local to the processor 110, which has instructions stored thereon that, when executed by the processor 110, cause the processor 110 to perform the processing operations of the circuit input solver 100.

The term "processor" or "processing circuit" is used herein to include any combination of hardware, firmware, and software, employed to process data or digital signals. Processing circuit hardware may include, for example, application specific integrated circuits (ASICs), general purpose or special purpose central processing units (CPUs), digital signal processors (DSPs), graphics processing units (GPUs), and programmable logic devices such as field programmable gate arrays (FPGAs). In a processing circuit, as used herein, each function is performed either by hardware configured, i.e., hard-wired, to perform that function, or by more general purpose hardware, such as a CPU, configured to execute instructions stored in a non-transitory storage medium. A processing circuit may be fabricated on a single printed wiring board (PWB) or distributed over several interconnected PWBs. A processing circuit may contain other processing circuits; for example, a processing circuit may include two processing circuits, an FPGA and a CPU, interconnected on a PWB.

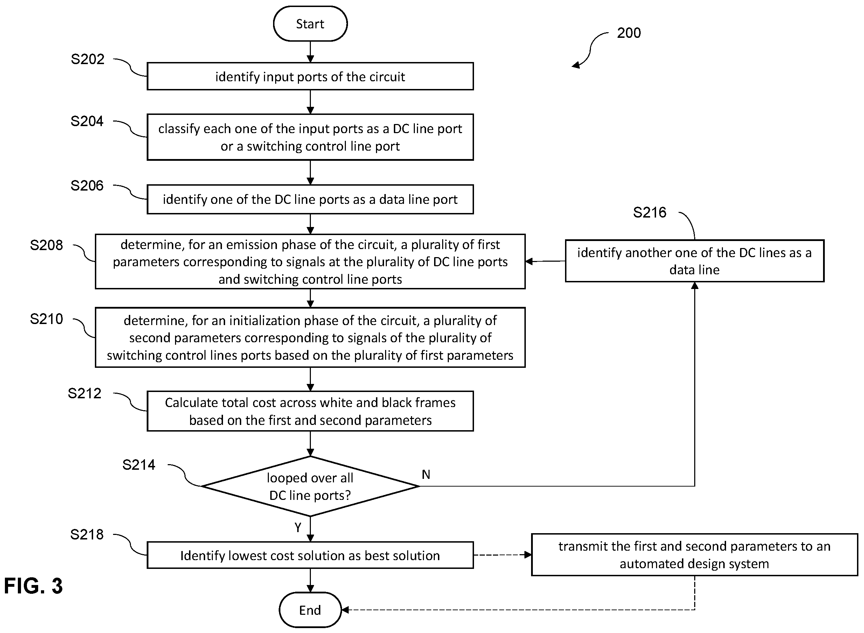

FIG. 3 illustrates the process 200 of designing inputs of a pixel circuit 50, according to some embodiments of the present disclosure.

In some embodiments, the circuit input solver 100 receives design parameters (corresponding to the circuit schematic) 102 of a pixel circuit 50 and uses that to identify the input ports of the circuit (S202). The design parameters 102 may be supplied by a circuit design system 10 that generates the circuit design of the pixel circuit 50. The circuit input solver 100 may do so by converting a circuit schematic of the circuit to a DC graph representation, and identifying the input ports based on the DC graph representation. The circuit input solver 100 may convert the circuit schematic to the DC graph representation by converting a capacitor of the circuit to an open circuit, converting a gate-source connection of a transistor of the circuit and a gate-drain connection of the transistor to an open circuit, converting a drain-source connection of the circuit to a short circuit, and converting a diode of the circuit to a short circuit.

The circuit input solver 100 then proceeds to classify each one of the input ports as a direct current (DC) line port or a switching control line port, thus identifying a plurality of DC line ports and switching control line ports (S204). The classification may include performing a graph gate search in a DC graph representation of the circuit. In some embodiments, the circuit input solver 100 identifies, through a DC graph representation, an input port (e.g., a first input port) that is not connected to (e.g., not directly connected to) a transistor gate as a DC line port, and identifies an input port (e.g., a second input port) that is connected to (e.g., directly connected to) a transistor gate as a switching control line port. By classifying the inputs as either DC or switching inputs, the search space may be greatly reduced, which could lead to faster results.

Once the type of each of the input ports of the pixel circuit 50 is identified, the circuit input solver 100 begins an evaluation run, by selecting one of the DC line ports as the data line port of the pixel circuit 50 (S206).

The circuit input solver 100 then determines, for an emission phase of the circuit, a plurality of first parameters corresponding to signals of the plurality of DC line ports and the plurality of switching control line ports (S208). The first parameters may include voltage levels at the plurality of DC line ports and at the plurality of switching control line ports, an emission voltage level at the data line port, signal types of switching signals associated with the plurality of switching control line ports, and a capacitance of a capacitor of the circuit. The signal types may include an active-low signal type and an active-high signal type, and the voltage levels may be between a set maximum value and a set minimum value (e.g., between -8 V and +8 V).

As part of the first parameters, the circuit input solver 100 may assign one or more dummy variables to each capacitor of the circuit (such as the storage capacitor), which correspond to the charge levels of the capacitor at successive white and black emission frames, and solves for these values along with the rest of the first values. A white frame may be observed when the OLED current is at a high level, and a black frame may be observed when the OLED current is at a low level. Treating the charge value of the capacitors as dummy variables allows for solving the emission phase independently of the initialization phase.

The circuit input solver 100 then solves (e.g., optimizes) the voltage levels of the plurality of DC line ports and the plurality of switching control line ports, an emission voltage level at the data line port, signal types of switching signals associated with the plurality of switching control line ports, and the one or more dummy variables based on one or more constraints (e.g., one or more first constraints). These may be soft switch constraints, such as a black light emission threshold and a white light emission threshold, which softly enforce the change in brightness between switching bright (e.g., white) and dark (e.g., black) frames during optimization. In some examples, the circuit input solver 100 utilizes a bayesian optimization algorithm to determine the first parameters; however, embodiments of the present disclosure are not limited thereto, and any suitable constrained solver (e.g., a gradient-free optimizer) may be employed.

Once the plurality of first parameters are determined for the emission phase, the circuit input solver 100 determines, for an initialization phase of the circuit, a plurality of second parameters corresponding to signals of the plurality of switching control line ports based on the plurality of first parameters (S210). Here, the plurality of second parameters may include voltage levels and timings of the switching signals (e.g., start and end times of the switching signals), voltage levels of a subset of the plurality of DC line ports, and an initialization voltage level at the data line port as well as timing and duration of the data signal.

Here, according to some embodiments, the circuit input solver 100 identifies those DC line ports that do not supply current to the OLED of the circuit during the emission phase of the circuit (i.e., the DC line ports that are cut off from the OLED during the emission phase) as the subset of DC line ports. The circuit input solver 100 then determines (e.g., optimizes) the timing parameters for the control/switching signals, voltages of DC signals of the subset of DC line ports, and initialization voltage level at the data line port (i.e., the second parameters) based on one or more constraints (e.g., one or more second constraints) during the initialization phase using a (constrained) black-box solver (e.g., a Bayesian optimizer). The constraints of the initialization phase may include a time gap between the data signal of the data line port and the switching signals of the plurality of switching control line ports, which sets a limit to how far apart in time the switching signals may be to the data signal. For example, the scan signals sent through the scan lines should at least partially overlap the data signal sent through the data line port to be meaningful. The constraints may further include a difference or ratio in currents of the OLED between black and white frames.

According to some embodiments, once the first and second parameters calculated, the circuit input solver 100 evaluates the results of the run by calculating the total value of a cost function across successive white and black emission frames (each of which includes an initialization phase and a black/white emission phase) (S212).

The circuit input solver 100 partially repeats the above process by looping over all possible data signal input ports. That is, unless all DC line ports have, at one point, been selected as a data line port (S214), the circuit input solver 100 assumes that a different one of the DC line ports (e.g., the next unselected DC line port) is the data line port (S216) and repeats the analysis of the emission and initialization phases (S208) and (S210) and calculates the corresponding total cost (S212).

After looping over all possible data line ports, the circuit input solver 100 identifies the pair of first and second parameters that produce the lowest total cost as the best/optimized solution (S218) for operating the pixel circuit 50. This pair of parameters define the input signals to the pixel circuit 50 during the initialization and emission phases of a frame.

In calculating the total cost, the circuit input solver 100 controls the pixel circuit 50 using the corresponding first and second parameters for at least two frames (e.g., four frames) that alternate between white and black emission. For black emission frames, the circuit input solver 100 calculates a first cost $C_B$ as

$$C_B = \max\left(0, \log\left[\frac{I_{measure(B)}}{I_{target(B)}}\right]\right) \qquad \text{EQ (1)}$$

where log() represents a logarithmic function, $I_{measure(B)}$ represents a measured current of the OLED of the pixel circuit 50 during the black emission frame, $I_{target(B)}$ represents a target OLED current during the black emission frame, and max($a$, $b$) is a function that returns a higher of the two values $a$ and $b$.

For white emission frames, the circuit input solver 100 calculates a second cost $C_W$ as

$$C_W = \max\left(0, \log\left[\frac{I_{target(W)}}{I_{measure(W)}}\right]\right) \qquad \text{EQ (2)}$$

where $I_{measure(W)}$ represents a measured current of the OLED of the pixel circuit 50 during the white emission frame, $I_{target(W)}$ represents a target LED current during the white emission frame.

Total cost $C$ is defined as the summation of the first and second costs, that is,

$$C = C_W + C_B \qquad \text{EQ (3)}$$

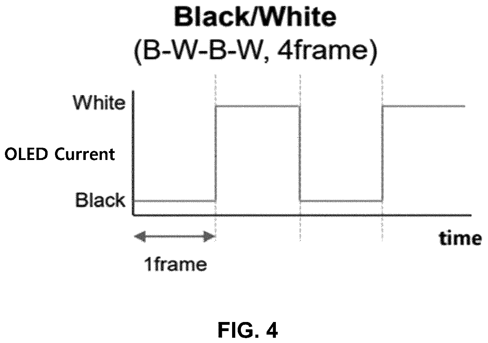

The circuit input solver 100 may measure the first and second costs across alternating black and white emission frames by summing the average first cost $C_B$ and average second cost $C_W$ to calculate the total cost $C$ for a given pairing of first and second parameters. In some examples, averaging may be performed over four frames of alternating black and white frames (B-W-B-W), which is illustrated in FIG. 4. A black emission frame may be defined as one having an emission OLED current less than or equal to a black light emission threshold $I_B$, and a white emission frame may be defined as one having an emission OLED current greater than or equal to a white light emission threshold $I_W$.

In some examples, the circuit input solver 100 may also transmit or output the first and second parameters (e.g., to an automated design system 20) for configuring a display device comprising the pixel circuit 50.

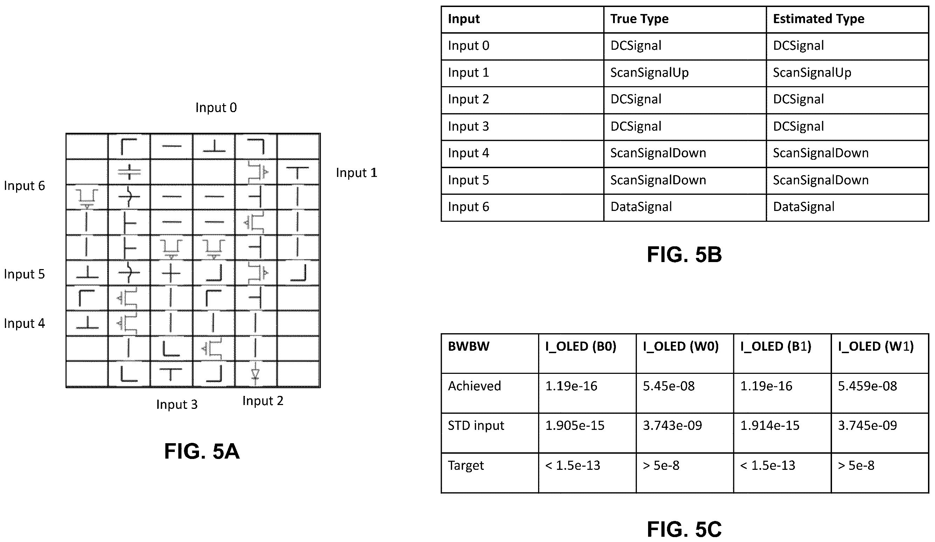

FIGS. 5A-5C illustrate the capability of the circuit input solver 100 to design the input signals to a sample pixel circuit as compared to human-designed input signals, according to some embodiments of the present disclosure.

FIG. 5A illustrates the DC graph representation of a sample pixel circuit including seven transistors and one storage capacitor (7T1C) and the input ports of the pixel circuit (i.e., inputs 1-7) as identified by the circuit input solver 100, according to some embodiments of the present disclosure. As shown, the circuit input solver 100 has correctly identified the input ports of the pixel circuit based on the DC graph representation.

The table of FIG. 5B compares the determined input types (Estimated Type) (e.g., signal type) of each identified input port with the actual input type (True Type) (as determined by a human designer), according to some embodiments of the present disclosure. As shown, the circuit input solver 100 has correctly identified the type of each input as a DC signal input or a scan/switching signal input and also correctly identified the high or low activation of each scan signal.

The table of FIG. 5C compares the OLED currents achieved by the circuit input solver 100 during each of four alternating black and white emission frames (B0-W0-B1-W1) with those of a human-design (STD input) and the corresponding target values (Target). As shown, the OLED currents achieved by the circuit input solver 100 satisfy all of the targets and improve upon the results achieved by a human-designer.

Accordingly, as described above, the circuit input solver 100 can automatically generate the input signals to any pixel circuit based on given performance metrics. The input signals generated by the circuit input solver 100 may be provided to an automated design system that can automatically configure/design control and drive circuitry of a display device that includes the pixel circuit. Thus, the circuit input solver 100 may aid or facilitate the automatic design and/or manufacture of the display device.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "and/or" includes any and all combinations of one or more of the associated listed items. For example, the expression "A and/or B" denotes A, B, or A and B. Expressions such as "one or more of" and "at least one of," when preceding a list of elements, modify the entire list of elements and do not modify the individual elements of the list. For example, the expression "one or more of A, B, and C," "at least one of A, B, or C," "at least one of A, B, and C," and "at least one selected from the group consisting of A, B, and C" indicates only A, only B, only C, both A and B, both A and C, both B and C, or all of A, B, and C.

Further, the use of "may" when describing embodiments of the inventive concept refers to "one or more embodiments of the present disclosure".

As used herein, the terms "use," "using," and "used" may be considered synonymous with the terms "utilize," "utilizing," and "utilized," respectively.

As used herein, the term "substantially," "about," and similar terms are used as terms of approximation and not as terms of degree, and are intended to account for the inherent deviations in measured or calculated values that would be recognized by those of ordinary skill in the art.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

The circuit input solver and/or any other relevant devices or components according to embodiments of the present invention described herein may be implemented utilizing any suitable hardware, firmware (e.g., an application-specific integrated circuit), software, or a suitable combination of software, firmware, and hardware. For example, the various components of the circuit input solver may be formed on one integrated circuit (IC) chip or on separate IC chips. Further, the various components of the circuit input solver may be implemented on a flexible printed circuit film, a tape carrier package (TCP), a printed circuit board (PCB), or formed on a same substrate. Further, the various components of the circuit input solver may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the invention.

Although aspects of some example embodiments of the system and method of automated circuit input design using a circuit input solver have been described and illustrated herein, various modifications and variations may be implemented, as would be understood by a person having ordinary skill in the art, without departing from the scope of embodiments according to the present disclosure. Accordingly, it is to be understood that an automated circuit input design system and method according to the principles of the present disclosure may be embodied other than as specifically described herein. The invention is defined in the following claims, and equivalents thereof.

**Claims**

1. A method of designing inputs of a circuit, the method comprising:

   identifying, by a circuit input solver, input ports of the circuit;
   classifying, by the circuit input solver, each one of the input ports as a DC line port of a plurality of DC line ports or a switching control line port of a plurality of switching control line ports;
   identifying, by the circuit input solver, one of the DC line ports as a data line port;
   determining, by the circuit input solver, for an emission phase of the circuit, a plurality of first parameters corresponding to signals of the plurality of DC line ports;
   determining, by the circuit input solver, for an initialization phase of the circuit, a plurality of second parameters corresponding to signals of the plurality of switching control line ports based on the plurality of first parameters; and
   transmitting, by the circuit input solver, the first and second parameters for configuring a display device comprising the circuit.

2. The method of claim 1, wherein the circuit is a pixel circuit, wherein the emission phase is immediately subsequent to the initialization phase.

3. The method of claim 1 or 2, wherein, during the initialization phase, the circuit is configured to charge a capacitor of the circuit to a charge level, and
   wherein, during the emission phase, the circuit is configured to emit light of an intensity corresponding to the charge level of the capacitor during the initialization phase.

4. The method of claim 1, 2, or 3, wherein the plurality of first parameters comprises voltage levels at the plurality of DC line ports and the plurality of switching control line ports, an emission voltage level of the data line port, signal types of switching signals associated with the plurality of switching control line ports, and a capacitance of a capacitor of the circuit, optionally, , wherein the signal types comprise an active-low signal type and an active-high signal type, and
   wherein the voltage levels are between a set maximum value and a set minimum value.

5. The method of any one of claims 1 to 4, wherein the plurality of second parameters comprises timings of switching signals associated with the plurality of switching control line ports, voltage levels of a subset of DC line ports from among the plurality of DC line ports, an initialization voltage level of the data line port, and a timing and a duration of a data signal at the data line port, optionally, wherein each DC line port of the subset of DC line ports does not supply current to a light emitting diode (LED) of the circuit during the emission phase of the circuit.

6. The method of any one of claims 1 to 5, further comprising:

   receiving, by the circuit input solver, design parameters of the circuit from a circuit design system,
   wherein the identifying the input ports of the circuit comprises:

converting, by the circuit input solver, the design parameters of the circuit to a DC graph representation; and
identifying, by the circuit input solver, the input ports based on the DC graph representation
optionally, wherein the converting the design parameters of the circuit to the DC graph representation comprises:

converting a capacitor of the circuit to an open circuit;
converting a gate-source connection of a transistor of the circuit and a gate-drain connection of the transistor to an open circuit;
converting a drain-source connection of the circuit to a short circuit; and
converting a diode of the circuit to a short circuit.

7. The method of any one of claims 1 to 6, wherein the classifying each one of the input ports comprises performing a graph gate search in a DC graph representation of the circuit.

8. The method of any one of claims 1 to 7, wherein classifying each one of the input ports comprises:

identifying, through a DC graph representation, a first input port of the input ports that is not connected to a transistor gate as the DC line port; and
identifying, through the DC graph representation, a second input port of the input ports that is connected to a transistor gate as the switching control line port.

9. The method of any one of claims 1 to 8, wherein the determining, for the emission phase of the circuit, the plurality of first parameters comprises:

associating one or more dummy variables with a capacitor of the circuit, the one or more dummy variables corresponding to charge levels of the capacitor at successive white and black emission frames; and
determining voltage levels of the plurality of DC line ports and the plurality of switching control line ports, an emission voltage level of the data line port, signal types of switching signals associated with the plurality of switching control line ports, and the one or more dummy variables based on one or more constraints, optionally, wherein the one or more constraints comprise:

a black light emission threshold; and
a white light emission threshold.

10. The method of any one of claim 1 to 9, wherein the determining, for the initialization phase of the circuit, the plurality of second parameters comprises:

identifying a subset of DC line ports from among the plurality of DC line ports that do not supply current to a light emitting diode (LED) of the circuit during the emission phase of the circuit; and
determining timings of switching signals associated with the plurality of switching control line ports, voltage levels of the subset of DC line ports, an initialization voltage level of the data line port, and a timing and a duration of a data signal at the data line port based on one or more constraints optionally, wherein the one or more constraints comprises:

a time gap between a data signal of the data line port and the switching signals of the plurality of switching control line ports; and
a difference or ratio in currents of a light emitting diode (LED) between black and white frames.

11. The method of any one of claim 1 to 10, further comprising:

calculating, by the circuit input solver, a total cost comprising a first cost associated with a black emission frame and a second cost associated with a white emission frame;
determining, by the circuit input solver, that the total cost is less than a previous total cost associated with a different one of the DC line ports being identified as the data line port; and
identifying, by the circuit input solver, the plurality of first and second parameters as corresponding to designed inputs of the circuit.

12. The method of claim 11, wherein the first cost is expressed as:

$$C_B = \max\left(0, \log\left[\frac{I_{measure(B)}}{I_{target(B)}}\right]\right),$$

where $C_B$ represents the first cost, log() represents a logarithmic function, $I_{measure(B)}$ represents a measured current of a light emitting diode (LED) of the circuit during the black emission frame, $I_{target(B)}$ represents a target LED current during the black emission frame, and max($a$, $b$) is a function that returns a higher of the two values $a$ and $b$.

13. The method of claim 11 or 12, wherein the second cost is expressed as:

$$C_W = \max\left(0, \log\left[\frac{I_{target(B)}}{I_{measure(W)}}\right]\right),$$

where $C_W$ represents the second cost, log() represents a logarithmic function, $I_{measure(W)}$ represents a measured current of a light emitting diode (LED) of the circuit during the white emission frame, $I_{target(W)}$ represents a target LED current during the white emission frame, and max($a$, $b$) is a function that returns a higher of the two values $a$ and $b$.

14. A computer program product comprising instructions which, when the program is run on a computer, cause the computer to perform the method of any one of claims 1 to 13.

15. A circuit input solver comprising:

a processor; and
a processor memory local to the processor, wherein the processor memory has stored thereon instructions that, when executed by the processor, cause the processor to perform:

identifying input ports of a circuit;
classifying each one of the input ports as a DC line port of a plurality of DC line ports or a switching control line port of a plurality of switching control line ports;
identifying one of the DC line ports as a data line port;
determining, for an emission phase of the circuit, a plurality of first parameters corresponding to signals of the plurality of DC line ports;

determining, for an initialization phase of the circuit, a plurality of second parameters corresponding to signals of the plurality of switching control line ports based on the plurality of first parameters; and
transmitting the first and second parameters for configuring a display device comprising the circuit.

**FIG. 1A**

**FIG. 1B**

EP 4 369 243 A1

Circuit Design System — 10

Circuit Schematic — 102

Circuit Input Solver — 100
Processor — 110
Memory — 120

Circuit Inputs — 104

Automated Design System — 20

Display Device — 30
Pixel Circuit — 50

**FIG. 2**

```
                              ┌──────────┐
                              │  Start   │
                              └────┬─────┘
                                   │
                                   ▼
S202 ──────────┐        ┌────────────────────────────────────┐
               └──────▶│   identify input ports of the circuit │
                        └────────────────┬───────────────────┘
                                         │
                                         ▼
S204 ──────────┐        ┌────────────────────────────────────┐
               └──────▶│ classify each one of the input ports │
                        │  as a DC line port or a switching    │
                        │          control line port           │
                        └────────────────┬───────────────────┘
                                         │
                                         ▼
S206 ──────────┐        ┌────────────────────────────────────┐
               └──────▶│ identify one of the DC line ports as │
                        │          a data line port            │
                        └────────────────┬───────────────────┘
```

200

```
S208                    ┌────────────────────────────────────┐      S216  ┌──────────────────────────┐
                        │ determine, for an emission phase of │◀──────────│ identify another one of  │
                        │ the circuit, a plurality of first   │           │ the DC lines as a        │
                        │ parameters corresponding to signals │           │ data line                │
                        │ at the plurality of DC line ports   │           └──────────────────────────┘
                        │ and switching control line ports    │
                        └────────────────┬───────────────────┘
                                         │
                                         ▼
S210                    ┌────────────────────────────────────┐
                        │ determine, for an initialization    │
                        │ phase of the circuit, a plurality of │
                        │ second parameters corresponding to  │
                        │ signals of the plurality of         │
                        │ switching control lines ports based │
                        │ on the plurality of first parameters│
                        └────────────────┬───────────────────┘
                                         │
                                         ▼
S212                    ┌────────────────────────────────────┐
                        │ Calculate total cost across white    │
                        │ and black frames based on the first  │
                        │      and second parameters           │
                        └────────────────┬───────────────────┘
                                         │
                                         ▼
S214                         ◇ looped over all ◇   N
                             ◇ DC line ports?  ◇──────────────▶
                                         │ Y
                                         ▼
S218                    ┌────────────────────────────────────┐      ┌──────────────────────────────┐
                        │ Identify lowest cost solution as    │─ ─ ─▶│ transmit the first and second│
                        │          best solution              │      │ parameters to an automated   │
                        └────────────────┬───────────────────┘      │      design system           │
                                         │                           └──────────────────────────────┘
                                         ▼
                              ┌──────────┐
                              │   End    │◀ ─ ─ ─ ─ ─ ─ ─ ─ ─ ─ ─ ─
                              └──────────┘
```

**FIG. 3**

**Black/White**
**(B-W-B-W, 4frame)**

FIG. 4

| Input | True Type | Estimated Type |
|---|---|---|
| Input 0 | DCSignal | DCSignal |
| Input 1 | ScanSignalUp | ScanSignalUp |
| Input 2 | DCSignal | DCSignal |
| Input 3 | DCSignal | DCSignal |
| Input 4 | ScanSignalDown | ScanSignalDown |
| Input 5 | ScanSignalDown | ScanSignalDown |
| Input 6 | DataSignal | DataSignal |

**FIG. 5B**

| BWBW | I_OLED (B0) | I_OLED (W0) | I_OLED (B1) | I_OLED (W1) |
|---|---|---|---|---|
| Achieved | 1.19e-16 | 5.45e-08 | 1.19e-16 | 5.459e-08 |
| STD input | 1.905e-15 | 3.743e-09 | 1.914e-15 | 3.745e-09 |
| Target | < 1.5e-13 | > 5e-8 | < 1.5e-13 | > 5e-8 |

**FIG. 5C**

**FIG. 5A**

Europäisches
Patentamt

European
Patent Office

Office européen
des brevets

# EUROPEAN SEARCH REPORT

Application Number

EP 23 20 9777

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/295473 A1 (LU TONG [GB] ET AL) 26 September 2019 (2019-09-26) * paragraph [0001] – paragraph [0003] * * paragraph [0050] – paragraph [0054] * * paragraph [0056] – paragraph [0057] * * figure 3 * * paragraph [0038] – paragraph [0041] * * paragraph [0043] – paragraph [0047]; figures 2, 6 * * figures 2, 3, 6, 8, 10 * | 1-15 | INV. G06F30/30 G09G3/3225 G09G3/3233 |
| A | US 2008/158110 A1 (IIDA YUKIHITO [JP] ET AL) 3 July 2008 (2008-07-03) * abstract; figure 2 * * paragraph [0165] – paragraph [0168]; figure 6a * | 1-15 | |
| A | US 2017/200412 A1 (GU JING [CN] ET AL) 13 July 2017 (2017-07-13) * abstract * * paragraph [0007] * * figure 10 * | 1-15 | TECHNICAL FIELDS SEARCHED (IPC) |
| A | US 11 189 225 B1 (HEGANOVIC ADNAN [GB] ET AL) 30 November 2021 (2021-11-30) * abstract; figures 1, 2 * | 1-15 | G06F G09G |

The present search report has been drawn up for all claims

| Place of search | Date of completion of the search | Examiner |
|---|---|---|
| Munich | 2 April 2024 | Ross, Christopher |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 20 9777

This annex lists the patent family members relating to the patent documents cited in the above-mentioned European search report.
The members are as contained in the European Patent Office EDP file on
The European Patent Office is in no way liable for these particulars which are merely given for the purpose of information.

02-04-2024

| Patent document cited in search report | | Publication date | Patent family member(s) | | Publication date |
|---|---|---|---|---|---|
| US 2019295473 | A1 | 26-09-2019 | CN | 110364120 A | 22-10-2019 |
| | | | US | 2019295473 A1 | 26-09-2019 |
| US 2008158110 | A1 | 03-07-2008 | CN | 101211535 A | 02-07-2008 |
| | | | JP | 2008164796 A | 17-07-2008 |
| | | | KR | 20080061268 A | 02-07-2008 |
| | | | TW | 200836152 A | 01-09-2008 |
| | | | US | 2008158110 A1 | 03-07-2008 |
| US 2017200412 | A1 | 13-07-2017 | CN | 108604436 A | 28-09-2018 |
| | | | CN | 108885855 A | 23-11-2018 |
| | | | EP | 3403256 A2 | 21-11-2018 |
| | | | EP | 3403257 A1 | 21-11-2018 |
| | | | US | 2017200412 A1 | 13-07-2017 |
| | | | US | 2018293942 A1 | 11-10-2018 |
| | | | US | 2024071308 A1 | 29-02-2024 |
| | | | WO | 2016141777 A2 | 15-09-2016 |
| | | | WO | 2017121166 A1 | 20-07-2017 |
| US 11189225 | B1 | 30-11-2021 | CN | 114255706 A | 29-03-2022 |
| | | | US | 11189225 B1 | 30-11-2021 |

EPO FORM P0459

For more details about this annex : see Official Journal of the European Patent Office, No. 12/82